# EUROPEAN PATENT APPLICATION

(11) **EP 0 547 328 A1**
(43) Date of publication of application: **23.06.1993**
(21) Application number: 92117648.3
(22) Date of filing: 15.10.1992
(51) Int. Cl.: B32B 31/00, F26B 5/14

(54) **Film sticking apparatus**

(30) Priority: 13.12.1991 JP 352371/91
(71) Applicant: SOMAR CORPORATION, Tokyo 104 (JP)
(72) Inventor: Taguchi, Hiroshi, Toshima-ku, Tokyo (JP); Sugimoto, Kiyoji, Noda-shi, Chiba (JP)
(74) Representative: Boeters, Hans Dietrich, Dr.

(57) **Abstract**

A film sticking apparatus which enhances the durability of a wiping roller, (78) which is used to wipe a pressure sticking roller (28) in order to prevent defective pressure sticking. The apparatus includes a wet roller, (48) which applies an air bubble generation preventive liquid, such as water, to a film-sticking surface of a base plate. (6) The liquid ensures that a stratified film is stuck to the base plate's surface without defects. The wiping roller (78) is turned in rotating contact with the pressure sticking roller (28) to remove excess liquid, which clings to the pressure sticking roller. The wiping surface portion of the wiping roller is made of a metal meshing, is highly durable and provides quick and sure removal of the clinging liquid from the pressure sticking roller.

## Description

### BACKGROUND OF THE INVENTION

This application is based on and claims priority from Japanese Application No. HEI 3-352371 filed December 13, 1991, the disclosure of which is incorporated by reference herein.

The present invention relates to a film sticking apparatus that includes a means for applying an air bubble generation preventive liquid, such as water, to the film-sticking surface of a base plate. The apparatus also includes a pressure sticking roller for sticking a film to the surface as the liquid remains applied thereto.

A printed circuit board for an electronic machine, such as a computer, has wiring made of copper or the like in a prescribed pattern on one or both sides of an electrically insulating base plate. In a process of manufacturing the printed circuit board, a stratified film is used that consists of a photosensitive resin layer, which is a photoresist layer, and a light-transmissible resin film, which is a protective film for protecting the layer. The stratified film is first stuck, under heat and pressure, to an electroconductive layer which is a thin copper film provided on the electrically insulating base plate.

This heat and pressure sticking operation is performed by a film sticking apparatus in a mass production manner. One such apparatus was proposed in the Japan Patent Applications (OPI) Nos. 208037/88 and 7344/91 filed by the present applicant (the term "OPI" as used herein means an "unexamined published application").

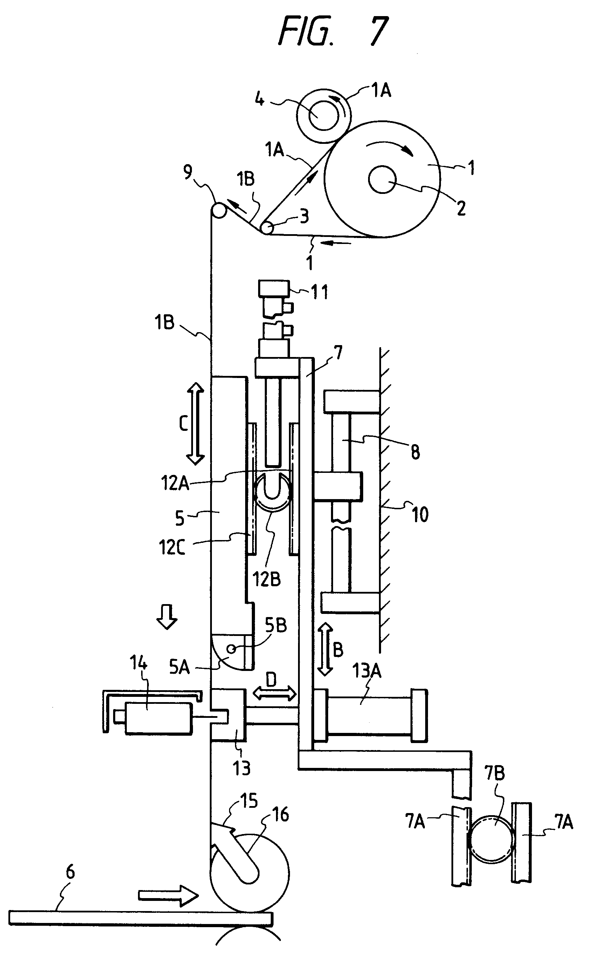

Fig. 7 is a side view of a conventional film sticking apparatus to illustrate the constitution and operation thereof. Since the apparatus is nearly symmetric above and below the conveyance passage for an electrically insulating base plate, Fig. 7 shows only the upper half of the apparatus. In the apparatus, a three-layer stratified film 1 is used that consists of three layers, a light-transmissible resin film, a photosensitive resin layer and another light-transmissible resin film. The stratified film is continuously wound on a supply roller 2 in advance. The stratified film 1 is unwound from the supply roller 2 so that a film separation roller 3 separates the film into the light-transmissible resin film 1A and a two-layer stratified film 1B. The two-layer film 1B consists of the other light-transmissible resin film and the photosensitive resin layer, which is exposed on one side thereof and is to be stuck to the base plate.

The separated stratified film 1B is fed to the surface of a main vacuum suction plate 5 (which is a film feed member) along a tension roller 9. An auxiliary vacuum suction plate 13 and a cutter 14 are provided at the feed passage for the stratified film 1B downstream of the main vacuum suction plate 5 with respect to the film feed direction. A vacuum suction bar 15 and a pressure sticking roller 16 are provided at the feed passage for the film 1B downstream of the cutter 14.

The pressure sticking roller 16 is generally made of a metal roller and a rubber sheet provided on the peripheral surface of the metal roller. The main vacuum suction plate 5 is for tentatively sticking the stratified film 1B to an electroconductive layer on the base plate 6 while holding the film on the suction plate by vacuum suction. The main vacuum suction plate 5 is supported by a support member 7 and is movable up and down (i.e. toward and away from the base plate 6) along directions B. The support member 7 is attached with a guide member 8 to the body frame 10 of the apparatus so that the support member can be moved in the directions B while sliding on the guide member 8.

A pair of support members 7 are provided with one above and one below the conveyance passage. The support members are moved up and down in conjunction with each other through the action of a rack and pinion mechanism by a driver not shown in Fig. 7. The mechanism includes racks 7A provided on the support members, and a pinion 7B engaged with the racks and supported by the body frame 10 of the apparatus.

The main vacuum suction plate 5 is supported by the support member 7 so that the suction plate can be moved toward and away from the base plate 6 in directions C, independently of the movement of the support member 7. A driver 11, such as a pneumatic cylinder, moves the support member 7 through the action of a rack and pinion mechanism 12A-12C. The mechanism includes a first rack 12A secured to the support member 7, a pinion 12B engaged with the rack and moveable up and down along the rack by the driver 11. The mechanism includes a second rack 12C secured to the suction plate 5 and engaged with the pinion that is moveable up and down in parallel with the former rack 12A.

The main vacuum suction plate 5 has a tentative-sticking downstream end portion 5A in which a heater 5B is provided. To tentatively stick the stratified film 1B to the base plate 6, the tentative-sticking downstream end portion 5A is moved to the vicinity of the base plate or into contact therewith (while the film remains stuck to the end portion). At that time, the portion 5A is heated by the heater 5B to tentatively stick the leading edge of the film 1B to the base plate 6 under heat and pressure.

The auxiliary vacuum suction plate 13 is used to ensure that the film's leading edge is attached to the portion 5A. Specifically, the auxiliary vacuum suction plate 13 first grasps the film's leading edge and thereafter, moves away from the feed passage along the direction D. A driver 13A, such as a pneumatic cylinder, is used to move the auxiliary vacuum suction plate 13 toward and away from the feed passage. The driver 13A is fastened to the support member 7. A cutter 14 is opposed to the auxiliary vacuum suction plate 13 across the feed passage and is used to cut off the film 1B to a desired length. The length corresponds to the length of the base plate 6.

In this apparatus, a pair of pressure sticking rollers 16 are also provided above and below the conveyance passage of the base plate 6. Once the leading edges of the upper and the lower stratified films 1B are tentatively stuck to the base plate 6, the remainder of the films are pinched thereon under a prescribed pressure by the pressure sticking rollers 16. The films are also heated by the rollers 16 so that the films are completely stuck to the base plate.

If an air bubble is generated between the base plate 6 and the stratified film 1B, a defective product is manufactured from the base plate through the use of the film. To prevent air bubble generation, an air bubble generation preventive liquid such as water is applied to the base plate 6 by a wet roller before the film 1B is stuck to the base plate. Generally, the surface area of the film 1B is usually smaller than the surface area of the entire side of the base plate 6. Consequently, the liquid applied to the edge of the base plate 6 is not covered by the film 1B and this liquid clings to the pressure sticking roller 16 when sticking the film to the base plate.

Further, when the film 1B is completely stuck to the base plate 6 by the pressure sticking roller, the liquid sometimes oozes out from the edge of the film and then clings to the roller. The liquid clinging to the roller 16 is transferred therefrom to the next stratified film 1B while sticking the film to the next base plate 6 and consequently acts as a mask during the exposure of the film to light, which produces wiring pattern defects. This liquid transfer also hinders the transfer of heat to the film which creates defects in the sticking operation. To prevent these problems, a wiping roller is provided for the pressure sticking roller 16 in order to wipe the liquid off the latter roller. The wiping surface of the wiping roller is made of felt, sponge or the like.

During operation, the pressure sticking roller 16 needs to transfer heat for the sticking operation to the stratified film 1B and the base plate 6. However, the heat is also transferred from the sticking roller 16 to the wiping roller when the latter roller is put in contact with the former roller. The wiping surface portion of the wiping roller is made of felt, sponge or the like, which is weakened by the heat and therefore the wiper roller has low durability. For that reason, the wiping capacity of the wiping roller is not stable and its ability to work effectively is likely to decrease.

Thus, the wiping roller may fail to wipe the air bubble generation preventive liquid off the pressure sticking roller 16 well enough. As noted above, the remaining liquid will create defects in the pressure Sticking of the film 1B. This is a problem. Moreover, since the wiping roller needs to be replaced often, due to its low durability, work loads for the wiping roller are heavy. This is also a problem.

### SUMMARY OF THE INVENTION

It is an object of the present invention to solve the above-mentioned problems. Accordingly, it is an object of the invention to provide a wiping roller for wiping an air bubble generation preventive liquid such as water off a pressure sticking roller in a film sticking apparatus, wherein the wiper roller's durability is increased to prevent defects caused by the liquid during pressure sticking of the film to the base plate.

The film sticking apparatus includes means for applying the liquid to the film-sticking surface of the base plate, so that the film is stuck to the surface by the pressure sticking roller, as the liquid remains applied to the surface. The apparatus also includes a wiping roller that is positioned in rotating contact with the pressure sticking roller to remove liquid clinging to the sticking roller. The wiping surface portion of the wiping roller is made of metal in order to solve the above noted problems and is constructed for absorbing the air bubble generation preventive liquid. The wiper roller structure may be a reticulate one, a porous one, or a striate one. The liquid wiped off the pressure sticking roller by the wiping roller may also be sucked into the latter roller and heat may be provided in the wiping roller.

The wiping roller provided in the film sticking apparatus in accordance with the present invention has a wiping surface portion made of the metal, and is turned in contact with the pressure sticking roller to remove the air bubble generation preventive liquid clinging thereto. The wiping roller is turned to continually provide a fresh wiping surface portion against the pressure sticking roller. The liquid wiped off the pressure sticking roller by the wiping roller undergoes evaporation or the like in order to maintain a dry wiping surface portion in contact with the pressure sticking roller. Since the wiping surface portion is made of the metal, the portion is highly resistant to wear from heat.

Therefore, even if heat for sticking the stratified film to the base plate is transferred from the pressure sticking roller to the wiping roller, the latter roller does not deteriorate. For that reason, the wiping capacity of the wiping roller is stabilized enough to ensure that the liquid is wiped off the pressure sticking roller. This ensures that the pressure sticking roller properly sticks the film to the base plate. Moreover, since the wiping surface portion is highly durable, the wiping roller does not need to be replaced often. This results in fewer interruptions in the apparatuses workflow, which improves work efficiency.

According to the present invention, the durability of a wiping roller for a pressure sticking roller is enhanced to prevent the sticking of a film from being made defective and to much shorten the time for the replacement of the wiping rollers to improve the efficiency of work or production. Desirable effects are thus produced.

If the wiping surface portion of the wiping roller has the reticulate, porous or striate structure for absorbing the liquid, a capillary phenomenon occurs. This capillary action raises the liquid absorbing capacity of the portion high enough to quickly and surely remove the air bubble generation preventive liquid from the surface of the pressure sticking roller. If the wiping surface portion has this structure, the surface area of the portion is large enough to accelerate the evaporation of the liquid removed from the pressure sticking roller by the wiping roller. As a result, the wiping surface portion coming into contact with the pressure sticking roller is always dry. If a heater is provided in the wiping roller, the evaporation is accelerated even more. A suction means may also be provided to suck the liquid into the wiping roller to more quickly and surely remove the liquid from the pressure sticking roller.

### BRIEF DESCRIPTION OF THE DRAWINGS

The invention will be more clearly understood from the following description in conjunction with the accompanying drawings, wherein:
Fig. 1 is a schematic view of the film sticking apparatus which is an embodiment of the present invention;
Fig. 2 is a schematic view of the upper half of the apparatus and the vicinity of a base plate conveyance passage;
Fig. 3 is a side view of the apparatus to illustrate the disposition of a wiping roller for a pressure sticking roller;
Fig. 4 is a perspective view of the wiping roller;
Fig. 5 is a block diagram of the control system of the apparatus to illustrate the input and output signals;
Fig. 6 is a flow chart of a procedure for sticking a film to a base plate under heat and pressure, which is performed by the apparatus; and
Fig. 7 is a side view of a conventional film sticking apparatus to illustrate the construction and operation thereof.

### DETAILED DESCRIPTION OF THE PREFERRED EMBODIMENT

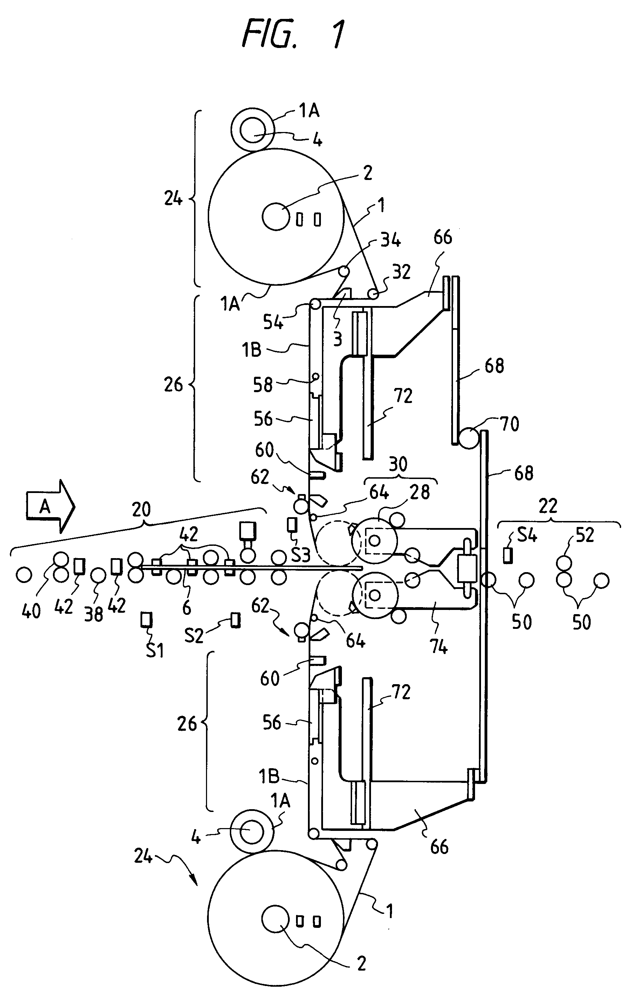

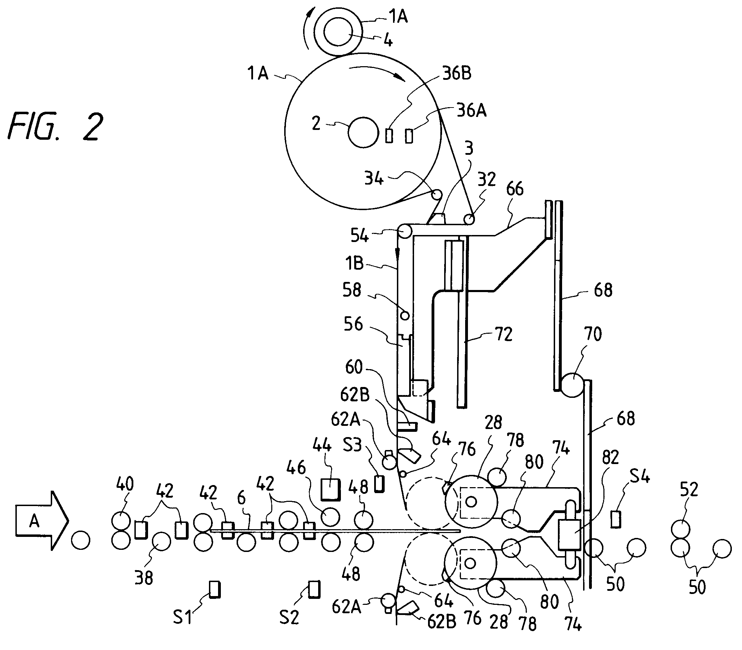

Fig. 1 is a schematic view of the present film sticking apparatus which operates to stick upper and lower stratified films 1B to upper and lower sides of a base plate 6. The film 1B has a length corresponding to that of the electrically insulating base plate 6. Fig. 2 shows the upper half of the apparatus in more detail, including the area surrounding the base plate conveyance passage, which acts as the center line for the upper and lower halves of the apparatus.

The apparatus mainly includes a base plate convey-in section 20 for conveying the base plate 6 to a tentative sticking position and a complete pressure sticking position. A base plate convey-out section 22 conveys out the base plate with the stratified films 1B completely stuck thereto under heat and pressure. Stratified film storage sections 24 store three-layer stratified films 1, each of which consists of a first light-transmissible resin film, a photosensitive resin layer and a second light-transmissible resin film. The storage sections 24 feed the two-layer stratified films 1B to the base plate. Each two-layer film consists of the first light-transmissible resin film and the photosensitive resin layer exposed on one side thereof. The photosensitive resin layer is stuck to the base plate during operation.

The apparatus also includes tentative sticking sections 26 for tentatively sticking the two-layer stratified films at the leading edges thereof to the film-stuck sides of the base plate. A pressure sticking section 30 operates to completely stick the two-layer stratified films 1B, which is tentatively stuck at its leading edges to the film-stuck sides of the base plate, to the sides of the base plate under heat and pressure from pressure sticking rollers 28.

In each of the stratified film storage sections 24, the three-layer stratified film 1 is stored in advance as a continuously wound roll. The film 1 is unwound from the supply roller 2 to a film separation roller 3 along a guide roller 32. The film separation roller 3 separates the film into the light-transmissible resin film 1A as a protective film, and the two-layer stratified film 1B. The separated light-transmissible resin film 1A is wound onto a winding roller 4 along a guide roller 34 and the three-layer stratified film 1. A large film winding diameter sensor 36A determines when the diameter of the stratified film 1 on the supply roller 2 is larger than a prescribed value. A small film winding diameter sensor 36B determines when the diameter is smaller than a prescribed value. These sensors 36A and 36B are provided alongside the film wound on the roller.

In the base plate convey-in section 20, a plurality of drive rollers 38 are provided at appropriate intervals along a base plate convey-in passage to apply driving conveyance forces to the base plate 6. Motive power is applied to the drive rollers 38 from a driver, such as a motor, to rotate the rollers. Idle rollers 40 are provided opposite every second drive roller 38 or appropriate driver rollers 38 across the base plate conveyance passage. Thus, the idle rollers and the drive rollers pinch the base plate 6 to properly apply the driving forces thereto.

Side positioners 42 are provided in appropriate positions between the drive rollers 38 along the conveyance passage to maintain the base plate 6 in a prescribed lateral position with respect to the conveyance passage. A base plate hold-down roller 46 is provided opposite the most downstream (in the conveyance direction) driver roller 38 and near the upstream end of the pressure sticking section 30. The hold-down roller 46 is positioned in the conveyance passage and can be moved up and down by a base plate hold-down means 44, such as a pneumatic cylinder.

When the base plate hold-down roller 46 is moved downward by the base plate hold-down means 44, the base plate 6 is pinched between the hold-down roller and the corresponding drive roller 38. This pinching action prevents vertical movement of the base plate as the stratified films 1B are tentatively stuck to the base plate and as the films are completely stuck thereto. Wet rollers 48, which are positioned downstream of the most downstream drive roller 38, are used to apply an air bubble generation preventive liquid such as water to the base plate. The liquid prevents air bubbles from being generated between the base plate and the stratified films 1B completely stuck thereto.

Sensors S1, S2 and S3 for the base plate 6 are provided near the base plate conveyance passage. The upstream sensor S1 is a sideways positioning start location sensor which detects the leading edge of the base plate 6 brought into the base plate convey-in section 20. When this leading edge is detected, the sensor S1 outputs a detection signal to initiate action of the side positioners 42. The intermediate sensor S2 is a base plate trailing edge sensor provided downstream of the side positioning start location sensor S1 in order to detect the trailing edge of the base plate 6. The downstream sensor S3 is a base plate leading edge sensor provided near the upstream end of the pressure sticking section 30 in order to detect the leading edge of the base plate 6.

The base plate convey-out section 22 includes a plurality of drive rollers 50 which are rotated by a motor to apply driving forces to the base plate 6 to convey it. Idle rollers 52 are provided opposite appropriate ones of the driver rollers 50 across the base plate conveyance passage so that the base plate 6 is pinched between the idle rollers and the drive rollers to apply the driving forces to the base plate. A base plate passing sensor S4 is provided in the convey-out section 22 near the downstream end of the pressure sticking section 30 in order to detect the passing of the base plate 6.

Each stratified film 1B is fed from the stratified film storage section 24 to the tentative sticking section 26 along a tension roller 54. The tension roller 54 applies an appropriate tensile force to the film between the supply roller 2 and the main vacuum suction plate 56 (which is a film feed member). This tensile force prevents the film from undergoing a wrinkle or the like while being fed to the main vacuum suction plate.

A static electricity eliminator 58 is provided at the feed passage for the stratified film 1B between the tension roller 54 and the main vacuum suction plate 56 to eliminate static electricity from the film. A film holding member 60, a cutter 62 and a support roller 64 are provided at the stratified film feed passage between the main vacuum suction plate 56 and the pressure sticking section 30.

The main vacuum suction plate 56 sucks the leading edge of the stratified film 1B onto the plate as the film is feed from the supply roller 2. The suction plate 56 moves toward the leading edge of the conveyed base plate 6 to tentatively stick the film to the upper or lower side of the base plate at the leading edge thereof. The suction plate 56 is secured to a mounting member 66 so that they are moved together. The upper and the lower main vacuum suction plates 56 simultaneously suck the upper and the lower films 1B thereto, and are simultaneously moved toward the base plate 6 to tentatively stick the films thereto.

The film holding member 60 sucks the stratified film 1B at the leading edge thereof on the member by negative pressure. The holding member is moved back along the direction A of the conveyance of the base plate 6 so that the film is sucked and wound on the tentative-sticking downstream end portion 56A of the main vacuum suction plate 56.

The cutter 62 has a rotary cutting member 62A and a fixed cutting member 62B having a straight cutting edge. The rotary cutting member 62A has a cutting edge, which extends in the form of a part of a spiral on the outer circumferential surface of the cylindrical member. The stratified film 1B being fed across the fixed cutting member 62B is cut off by the cutter 62 perpendicularly to the film feeding direction as the rotary cutting member 62A is rotated to approach the fixed cutting member. The cutter 62 cuts the film to a prescribed length corresponding to that of the base plate 6. In order to cut the film 1B perpendicular to the film feed direction, one end of each of the rotary 62A and the fixed cutting members 62B is moved in the film feed direction during film feeding. This motion ensures that the speed of the movement of the cutoff point of the cutter, in the film feed direction, will equal the film feeding speed.

The support roller 64 is provided along the film feed passage between the cutter 62 and the pressure sticking roller 28. The roller 64 is located in the same plane as the film feed passage on the suction surface of the main vacuum suction plate 56 in order to guide the stratified film 1B. This guiding operation ensures that the trailing edge of the film is correctly sent to the pressure sticking roller 28 after the cutting operation, in order to prevent wrinkles or the like in the film.

The upper and the lower mounting members 66, to which the upper and the lower main vacuum suction plates 56 are secured, are provided similarly to each other as shown in Fig. 1. Racks 68 are provided on the mounting members 66 and engaged with a pinion 70 to simultaneously move the mounting members toward the base plate 6 together with the main vacuum suction plates 56 while sliding on guide rails 72. The pinion 70 is rotated in a prescribed position on the body frame of the apparatus by a servomotor through an electromagnetic clutch. The pinion 70 simultaneously moves the upper and the lower racks 68 and the upper and the lower main vacuum suction plate 56.

A pair of pneumatic cylinders are coupled to the upper and the lower mounting members 66 along the directions of the widths of the main vacuum suction plates 56 to simultaneously move the mounting members 66 away from each other. The servomotor is driven to move the main vacuum suction plates 56 toward the base plate 6 to set a prescribed distance between the base plate and each main vacuum suction plate. After that, the electromagnetic clutch is disengaged, and the pneumatic cylinders are driven to move the main vacuum suction plates 56 to tentatively stick the leading edge of the stratified films 1B to the leading edge of the base plate 6. Thereafter, the cylinders are driven back to move the main vacuum suction plates away from the base plate.

The pressure sticking section 30 includes the pressure sticking rollers 28 for completely sticking the stratified films 1B to the base plate 6 under heat and pressure. Pressure sticking roller support members 74 supports the rollers to move them back and forth. Vacuum suction bars 76 turn around the rollers while sucking the films on the bars. Pressure roller wiping rollers 78 wipe the air bubble generation preventive liquid off the pressure sticking rollers. Base plate wiping rollers 80 wipe the liquid off the upper and the lower sides of the base plate 6 after the complete sticking of the films thereto. Two pneumatic cylinders 82 swing the upper and the lower pressure sticking roller support members symmetrically to each other to vertically move the pressure sticking rollers to completely stick the films to the base plate.

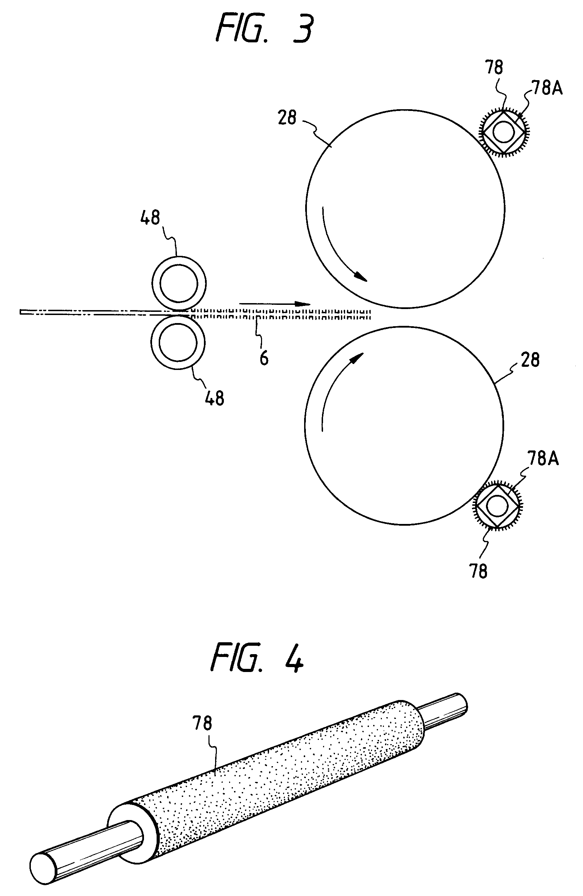

The wiping rollers 78 are provided in appropriate positions away from the pressure sticking points of the pressure sticking rollers 28, as shown in Fig. 3. The rollers 78 are supported with bearings 78A by the pressure sticking roller support members 74. The wiper rollers 78 are rotated by the pressure sticking rollers 28 as the wiper rollers are kept in contact with the sticking rollers by the weight of the wiper rollers or the urging forces of springs.

The outer circumferential surface portion of each wiping roller 78 is made of a meshing of a metal as shown in Fig. 4. The meshed metal is very heat resistant. Thus, heat from the pressure sticking roller 28 does not substantially effect the wiper surface portion. This, increases the wiping capacity of each wiping roller 78 and provides reliable liquid wiping from the pressure sticking roller 28 by the wiping roller. This ensures that any liquid that sticks to the sticking roller does not interfere with sticking of the film to the base plate. Since the outer circumferential surface portion of the wiping roller 78 is highly durable, the roller does not need to be replaced often. Therefore, the work efficiency is enhanced.

Since the meshing of the wiping roller 78 quickly absorbs the air bubble generation preventive liquid from the pressure sticking roller 28 by capillary action, the liquid can be rapidly and surely removed therefrom. The wiping surface portion of the wiping roller 78 is not confined to a mesh construction, but may be made of different structures capable of absorbing the liquid. For example, the wiping surface portion may be made of a finely protruded and recessed structure such as an aventurine structure, or a bundle of thin sticks. The wiping roller 8 may be either solid or hollow. If it is hollow, dry air, hot air or the like can be blown into the roller to accelerate the drying thereof to enhance the liquid removing capacity thereof. The base plate wiping rollers 80 are rotatably supported by the pressure sticking roller support members 74 downstream of the pressure sticking rollers 28 with regard to the direction of the conveyance of the base plate 6. Rollers 80 wipe the air bubble generation preventive liquid off the base plate 6. The right and the left pneumatic cylinders 82 are provided for the right pair of upper and lower support members 74 and the left pair of upper and lower support members 74 to vertically move the pressure sticking rollers 28.

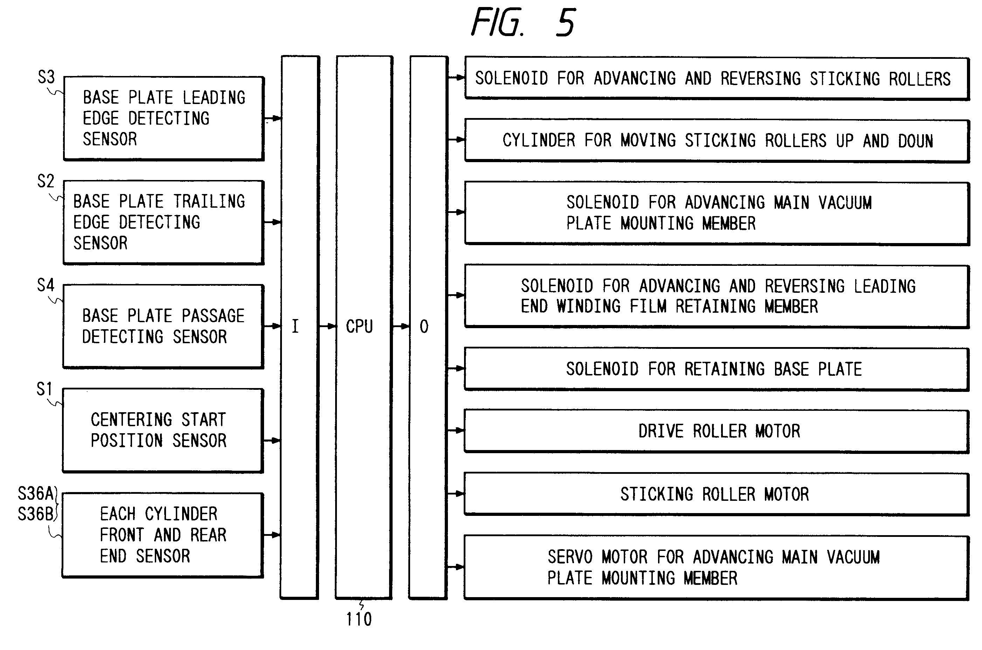

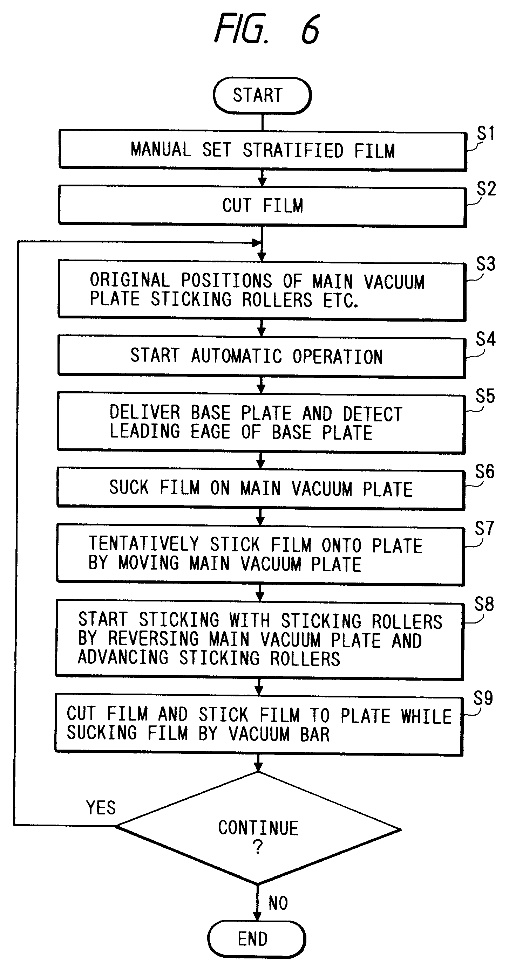

Fig. 5 is a block diagram to illustrate the signal lines of the control system of the film sticking apparatus. In the control system, a central control unit 110 sends out control signals for solenoids for the pneumatic cylinders and the motors. The control unit sends control signals in response to detection signals from the sensors S1, S2, S3, S4, S36A and S36B, and other sensors which are not shown in the drawings but are for detecting the front and rear ends of the piston rods of the cylinders. The central control unit 110 also performs counting and timing functions as well, and controls the apparatus in the procedure shown in Fig. 6. For example, the control unit 110 is made of a programmable controller or a relay sequence control circuit.

The operation of the film sticking apparatus is described in detail hereafter in connection with the procedures shown in Fig. 6. Since the upper and lower halves of the apparatus are operated symmetrically with respect to each other, the operation of the upper half is mainly described hereinafter.

The apparatus is manually put in a film sticking start preparation state in step 1. At that time, the supply roller 2 with the three-layer stratified film 1 wound thereon is set in the apparatus. The film is unwound from the roller along the guide roller 32 and separated into the light-transmissible resin film 1A and the two-layer stratified film 1B by the film separation roller 3. The separated two-layer stratified film is extended along the main vacuum suction plate 56 and the cutter 62 while being passed through the gap between the rotary and fixed cutting members 62A and 62B of the cutter. The cutting members can be manually separated to pass the film between the rotary and fixed members.

The stratified film 1B is thereafter cut off by the cutter 62 in step 2. At that time, the rotary cutting member 62A is manually rotated for the cutoff since the rotary and the fixed cutting members 62A and 62B are not inclined. The main vacuum suction plate 56, the pressure sticking roller 28 and so forth are put in their initial positions in step 3. At that time, the upstream end of the main vacuum suction plate 56 is located slightly below the highest ascent position of the end, and the film feed surfaces of the plate and the film holding member 60 are put on the same plate.

The apparatus is thereafter placed in an automatic operating state in step 4. As a result, the film holding member 60 sucks the stratified film 1B onto the member. Thereafter, the holding member 60 moves along the conveyance direction of the base plate 6. This motion causes the film to be unwound and the leading edge thereof to be sucked against the tentative-sticking downstream end portion 56A. The base plate 6 is brought into the base plate convey-in section 20. Once the base plate is detected by the side positioning start location sensor S1, the base plate is moved laterally by the side positioners 42 until it reaches a prescribed sideways position.

When the leading edge of the base plate 6 is positioned laterally into place and is conveyed in the conveyance passage, it is detected by the base plate leading edge sensor S3. Sensor S3 outputs a detection signal, which starts a counter in the central control unit 110. The counter counts for a prescribed time. When the counting operation has been performed for the prescribed time, the leading edge of the base plate 6 is stopped in the tentative sticking position. The detection signal also causes another counter in the control unit 110 to start counting. When this second counting operation has completed, the holding member 60 is moved back along the conveyance direction of the base plate 6. Thereafter, the holding member 60 again unwinds the stratified film 1B and pulls it into contact with the tentative-sticking downstream end portion 56A, in order that the end portion 56A may attach itself to the film.

As the main vacuum suction plate 56 moves down to tentatively stick the stratified film 1B to the base plate 6, the base plate hold-down means 44 is also drive to move the base plate hold-down roller 46 down. When the roller 46 is moved down to the base plate, it pinches the base plate between the roller 46 and the drive roller 38. The main vacuum suction plate 56 is then moved down to tentatively stick the leading edge of the stratified film 1B to the leading edge of the base plate 6 in step 7.

During the second counting operation, a servomotor is driven to simultaneously move the upper and the lower main vacuum suction plates 56 toward the upper and lower sides of the base plate 6 through the actions of the pinion 70 and the racks 68. The servomotor is stopped when each of the downstream ends of the main vacuum suction plates 56 are moved to a position about 2 cm from the base plate 6. After that, the pair of pneumatic cylinders, provided along the widths of the upper and the lower main vacuum suction plates 56, are driven to move the plates. This enables the tentative-sticking downstream end portions 56A thereof to approach the upper and lower sides of the base plate 6 to tentatively stick the stratified films 1B to the upper and lower sides of the base plate under the pushing power of the cylinders. For that reason, the films 1B can be tentatively stuck to both sides of the base plate 6 by mutually equal forces. At that time, the electromagnetic clutch is disengaged to keep the motive power of the servomotor from being transmitted to the pinion 70.

After which the main vacuum suction plate 56 is moved away from the base plate 6, and the pressure sticking roller 28 is moved forth. This prevents interference with the tentative-sticking downstream end portion 56A of the suction plate. Next, the rollers 28 start completely sticking the tentatively-stuck stratified film 1B to the base plate under heat and pressure, in step 58. When the portion of the stratified film 1B, which corresponds to the trailing edge of the plate, moves the cutter 62, the film is sucked onto the main vacuum suction plate 56 and cut by the cutter in step S9.

At the beginning of the cutoff operation, the cutter 62 is inclined so that the speed of the movement of the cutting point in the film feeding direction, equals the feeding speed. This ensures that the film is cut perpendicularly to the feeding direction. During and after the cutoff operation, the film 1B is guided by the support roller 64 so that even if the diameter of the pressure sticking roller 28 is small, the film is fed forth without sliding on the fixed cutting member 62B of the cutter 62. During the sticking operation band after the cutting operation, the vacuum suction bar 76 starts sacking the film 1B against the bar. This ensures that the film will slip on the outer surface of the bar while being completely stuck to the base plate 6 under heat and pressure.

When the trailing edge of the film 1B has come to the vicinity of the vacuum suction bar 76, the bar is turned around the pressure sticking roller 28 toward the base plate. This turning operation enables the bar to keep sucking the film against the bar until immediately before the termination of the sticking operation. For that reason, an appropriate tensile force is applied to the film 1B to prevent it from undergoing a wrinkle or the like. After the film 1B is cut off by the cutter 62, the main vacuum suction plate 56 and the film holding member 60 suck the following stratified film 1B to hold it on the plate and the member.

It is thereafter judged whether the film sticking operation of the apparatus should be continued or not. If it is judged that the film sticking operation should be continued, the steps 5, 6, 7, 8 and 9 are taken again. If it is not judged so, the operation is ceased.

The present invention is not confined to the above-described embodiment, but may be embodied or practiced in other various ways without departing from the scope or spirit of the invention. For example, the wiping roller 78 for the pressure sticking roller 28 may be applied to other types of film sticking apparatuses.

## Claims

1. A film sticking apparatus for sticking a film to a base plate, comprising:
means for conveying a base plate along a conveyance path to a pressure sticking section,
means for feeding a film along a film feeding path to said pressure sticking section,
a pressure sticking roller, positioned in the pressure sticking section, for sticking said film to a film-sticking surface of the base plate,
wetting means for applying an air bubble preventive liquid to one of the film and the film-sticking surface of the base plate before said film is stuck to the base plate,
a wiper for removing the air bubble preventive liquid from the pressure sticking roller, wherein a wiping surface of said wiper that contacts the pressure sticking roller is made of metal.

2. A film sticking apparatus according to claim 1, wherein said wiping surface of the wiper absorbs the air bubble preventive liquid.

3. A film sticking apparatus according to claim 2, wherein said wiping surface is reticulate.

4. A film sticking apparatus according to claim 2, wherein said wiping surface is porous.

5. A film sticking apparatus according to claim 2, wherein said wiping surface is striate.

6. A film sticking apparatus according to claim 1, further comprising vacuum means for sucking the air bubble preventive liquid, which is removed from the pressure sticking roller, off the wiping surface of the wiper.

7. A film sticking apparatus according to claim 1, further comprising evaporation means for causing the air bubble preventive liquid on the wiping surface of the wiper to evaporate.

8. A film sticking apparatus according to claim 7, wherein said evaporation means is a heater which causes the air bubble preventive liquid to evaporate.

9. A film sticking apparatus according to claim 7, wherein said wiper includes:
pressure roller wiping rollers for wiping air bubble preventive liquid off the pressure sticking rollers, and
base plate wiping rollers for wiping air bubble preventive liquid off upper and lower sides of the base plate after the film has been stuck to the base plate.

10. A film sticking apparatus according to claim 1, further comprising a pneumatic cylinder, connected to the pressure sticking roller, for vertically swing the pressure sticking roller toward and away from the conveyance passage of the base plate.

11. A film sticking apparatus according to claim 7, further comprising:
first and second wiping rollers for removing said air bubble preventive liquid,
a roller support member for supportably moving the first wiping rollers toward and away from the conveyance passage of the base plate, and
bearings for connecting said wiping rollers to the roller support member.

12. A film sticking apparatus according to claim 11, wherein said roller support member rotatably supports said pressure sticking rollers and said second wiping rollers, such that said second wiping rollers remain in rotating contact with the pressure sticking rollers throughout operation of said apparatus.

13. A film sticking apparatus according to claim 11, wherein said wiper include an outer circumferential surface portion which is made of meshed metal.

14. A film sticking apparatus according to claim 1, wherein said wiper includes wiping rollers having an outer circumferential surface portion which is made of meshed metal.

15. A film sticking apparatus according to claim 1, wherein said wiper includes wiping rollers, positioned in rotating contact with the pressure sticking rollers, for wiping air preventive liquid off the pressure sticking rollers.

16. A film sticking apparatus according to claim 1, wherein said wiper includes wiping rollers positioned in rotating contact with the base plate for wiping air preventive liquid off the base plate after the film has been stuck to the base plate.
